# EUROPÄISCHE PATENTSCHRIFT

(11) **EP 2 550 684 B1**
(45) Veröffentlichungstag und Bekanntmachung des Hinweises auf die Patenterteilung: **03.05.2017**
(21) Anmeldenummer: 11706242.2
(22) Anmeldetag: 02.03.2011
(51) Int. Cl.: H01L 33/56, H01L 33/50, H01L 33/62, H01L 33/54

(54) **STRAHLUNGSEMITTIERENDES HALBLEITERBAUTEIL**
RADIATION-EMITTING SEMICONDUCTOR COMPONENT
COMPOSANT SEMI-CONDUCTEUR ÉMETTEUR DE RAYONNEMENT

(30) Priorität: 24.03.2010 DE 102010012602
(43) Veröffentlichungstag der Anmeldung: 30.01.2013
(60) Teilanmeldung: 17161502.4
(73) Patentinhaber: OSRAM Opto Semiconductors GmbH, 93055 Regensburg (DE)
(72) Erfinder: WITTMANN, Michael, 93087 Alteglofsheim (DE)
(74) Vertreter: Epping - Hermann - Fischer
(86) Internationale Anmeldenummer: PCT/EP2011/053103
(87) Internationale Veröffentlichungsnummer: WO 2011/117049

(56) Entgegenhaltungen:
- EP-A1- 1 609 835
- DE-A1-102007 029 369
- DE-A1-102007 060 206

## Beschreibung

Es wird ein strahlungsemittierendes Halbleiterbauteil angegeben.

DE102007029369 A1 offenbart ein optoelektronisches Halbleiterbauelement mit einem Chip-Anschlussbereich der vollständig mit Licht absorbierendem Material abgedeckt ist.

Gemäß der erfindungsgemäßen Ausführungsform des strahlungsemittierenden Halbleiterbauteils umfasst das Halbleiterbauteil einen Chip-Anschlussbereich. Der Chip-Anschlussbereich ist ein Bereich, der zur Montage zumindest eines strahlungsemittierenden Halbleiterchips auf dem Chip-Anschlussbereich vorgesehen ist. Beispielsweise ist der Chip-Anschlussbereich mit einer Metallisierung oder mit einem Metallkörper gebildet. Insbesondere weist der Chip-Anschlussbereich eine größere Reflektivität für sichtbares Licht auf als ihn umgebende Bereiche des strahlungsemittierenden Halbleiterbauteils.

Das strahlungsemittierende Halbleiterbauteil umfasst gemäß der erfindungsgemäßen Ausführungsform einen strahlungsemittierenden Halbleiterchip. Bei dem strahlungsemittierenden Halbleiterchip handelt es sich um einen Halbleiterchip, der elektromagnetische Strahlung im Wellenlängenbereich zwischen Infrarotstrahlung und UV-Strahlung im Betrieb emittiert. Beispielsweise strahlt der strahlungsemittierende Halbleiterchip im Betrieb sichtbares Licht ab. Bei dem strahlungsemittierenden Halbleiterchip handelt es sich beispielsweise um einen Lumineszenzdiodenchip, also um einen Laserdiodenchip oder um einen Leuchtdiodenchip.

Gemäß der erfindungsgemäßen Ausführungsform des strahlungsemittierenden Halbleiterbauteils umfasst das strahlungsemittierende Halbleiterbauteil ein Licht absorbierendes Material. Das Licht absorbierende Material ist dazu vorgesehen, zumindest einen Teil der auf das Licht absorbierende Material auftreffenden elektromagnetischen Strahlung im sichtbaren Bereich zu absorbieren. Beispielsweise werden höchstens 25 % des Lichtes im sichtbaren Bereich, das auf die Außenfläche des Licht absorbierenden Materials trifft, reflektiert oder reemittiert. Bevorzugt werden höchstens 15 %, besonders bevorzugt höchstens 5 % des auftreffenden Lichtes im sichtbaren Bereich zurückgeworfen. Beispielsweise ist das Licht absorbierende Material schwarz ausgebildet.

Gemäß der erfindungsgemäßen Ausführungsform des strahlungsemittierenden Halbleiterbauteils ist der strahlungsemittierende Halbleiterchip am Chip-Anschlussbereich befestigt. Der strahlungsemittierende Halbleiterchip kann dabei am Chip-Anschlussbereich auch elektrisch kontaktiert sein. Ferner ist es möglich, dass mehrere strahlungsemittierende Halbleiterchips auf einem Chip-Anschlussbereich befestigt sind. Die Grundfläche des Chip-Anschlussbereichs ist vorzugsweise so gewählt, dass der strahlungsemittierende Halbleiterchip oder die strahlungsemittierenden Halbleiterchips in Summe eine Querschnittsfläche aufweisen, die kleiner ist als die Grundfläche, so dass der oder die strahlungsemittierenden Halbleiterchips den Chip-Anschlussbereich nicht vollständig überdecken. Dies erweist sich insbesondere als vorteilhaft, da auf diese Weise die Platzierung des strahlungsemittierenden Halbleiterchips auf dem Chip-Anschlussbereich mit einer gewissen Toleranz erfolgen kann.

Gemäß der erfindungsgemäßen Ausführungsform des strahlungsemittierenden Halbleiterbauteils ist der Chip-Anschlussbereich an Stellen, an denen er vom strahlungsemittierenden Halbleiterchip unverdeckt ist, mit dem Licht absorbierenden Material bedeckt. Das heißt, Bereiche des Chip-Anschlussbereichs, die freiliegen würden, weil der strahlungsemittierende Halbleiterchip sie nicht bedeckt, werden teilweise mit dem Licht absorbierenden Material abgedeckt.

Gemäß der erfindungsgemäßen Ausführungsform des strahlungsemittierenden Halbleiterbauteils ist der strahlungsemittierende Halbleiterchip stellenweise frei vom Licht absorbierenden Material. Das heißt, der strahlungsemittierende Halbleiterchip ist nicht vollständig vom Licht absorbierenden Material überdeckt, sondern beispielsweise zumindest die dem Chip-Anschlussbereich abgewandte Oberfläche des strahlungsemittierenden Halbleiterchips bleibt vollständig oder teilweise frei vom Licht absorbierenden Material. Beispielsweise kann das Licht absorbierende Material an Seitenflächen des strahlungsemittierenden Halbleiterchips direkt an diesen grenzen.

Gemäß der erfindungsgemäßen Ausführungsform des strahlungsemittierenden Halbleiterbauteils umfasst das strahlungsemittierende Halbleiterbauteil einen Chip-Anschlussbereich, einen strahlungsemittierenden Halbleiterchip, der am Chip-Anschlussbereich befestigt ist und ein Licht absorbierendes Material, das den Chip-Anschlussbereich an Stellen, an denen er vom strahlungsemittierenden Halbleiterchip unverdeckt ist, bedeckt, wobei der strahlungsemittierende Halbleiterchip stellenweise frei vom Licht absorbierenden Material ist. Es ist insbesondere möglich, dass das Licht absorbierendes Material auf den Chip-Anschlussbereich aufgebracht wird, nachdem der Chip am Chip-Anschlussbereich befestigt worden ist. Zum Beispiel Seitenflächen des Chips können daher vom Licht absorbierendes Material bedeckt sein.

Gemäß der erfindungsgemäßen Ausführungsform des strahlungsemittierenden Halbleiterbauteils umfasst das strahlungsemittierende Halbleiterbauteil einen Draht-Anschlussbereich. Der Draht-Anschlussbereich ist beispielsweise mit einer Metallisierung oder einem Metallkörper gebildet. Insbesondere unterscheidet sich der Draht-Anschlussbereich durch seine höhere Reflektivität für sichtbares Licht vom ihm umgebenden Material.

Gemäß der erfindungsgemäßen Ausführungsform des strahlungsemittierenden Halbleiterbauteils umfasst das strahlungsemittierende Halbleiterbauteil einen Draht, der den Draht-Anschlussbereich elektrisch leitend mit dem strahlungsemittierenden Halbleiterchip verbindet. Beispielsweise ist der strahlungsemittierende Halbleiterchip dann einerseits über den Chip-Anschlussbereich und andererseits über den Draht elektrisch leitend kontaktiert.

Gemäß der erfindungsgemäßen Ausführungsform des strahlungsemittierenden Halbleiterbauteils ist der Draht-Anschlussbereich an Stellen, an denen er vom Draht unverdeckt ist, mit dem Licht absorbierenden Material bedeckt. Das heißt, beispielsweise Licht reflektierende Bereiche des Draht-Anschlussbereichs, die ohne das Licht absorbierende Material frei zugänglich und Licht reflektierend wären, werden mit dem Licht absorbierenden Material bedeckt. Dabei ist es möglich, dass auch Teile des Drahtes mit dem Licht absorbierenden Material bedeckt sind. Im Extremfall kann der gesamte Draht mit dem Licht absorbierenden Material bedeckt sein.

Gemäß zumindest einer Ausführungsform des strahlungsemittierenden Halbleiterbauteils umfasst das strahlungsemittierende Halbleiterbauteil einen einzigen Chip-Anschlussbereich, einen einzigen strahlungsemittierenden Halbleiterchip und einen einzigen Draht-Anschlussbereich. Bei dem strahlungsemittierenden Halbleiterchip kann es sich dann um einen strahlungsemittierenden Halbleiterchip handeln, der beispielsweise infrarote Strahlung, farbiges sichtbares Licht oder weißes Licht emittiert.

Gemäß zumindest einer Ausführungsform des strahlungsemittierenden Halbleiterbauteils umfasst das strahlungsemittierende Halbleiterbauteil zwei Chip-Anschlussbereich, einen einzigen strahlungsemittierenden Halbleiterchip und keinen Draht-Anschlussbereich. Bei dem strahlungsemittierenden Halbleiterchip kann es sich dann um einen strahlungsemittierenden Halbleiterchip handeln, der beispielsweise infrarote Strahlung, farbiges sichtbares Licht oder weißes Licht emittiert.

Gemäß zumindest einer Ausführungsform des strahlungsemittierenden Halbleiterbauteils umfasst das strahlungsemittierende Halbleiterbauteil zumindest zwei strahlungsemittierende Halbleiterchips. Beispielsweise kann es sich bei dem strahlungsemittierenden Halbleiterbauteil dann um ein Halbleiterbauteil handeln, das einen rotes Licht emittierenden Halbleiterchip, einen blaues Licht emittierenden Halbleiterchip und einen grünes Licht emittierenden Halbleiterchip umfasst. Jeder der Halbleiterchips kann mittels je zwei Chip-Anschlussbereichen oder je zwei Draht-Anschlussbereichen oder mittels je einen Chip-Anschlussbereich und einen Draht-Anschlussbereich elektrisch kontaktiert sein.

Unabhängig davon, wie viele Chip-Anschlussbereiche, strahlungsemittierende Halbleiterchips und Draht-Anschlussbereiche das strahlungsemittierende Halbleiterbauteil umfasst, sind die vorhandenen Draht-Anschlussbereiche und Chip-Anschlussbereiche an Stellen, an denen sie durch andere Komponenten des Halbleiterbauteils nicht verdeckt sind, mit dem Licht absorbierenden Material bedeckt. Dabei kann das Licht absorbierende Material gezielt dort aufgebracht sein, wo es einen Anschlussbereich abdeckt. Ferner ist es möglich, dass das Licht absorbierende Material flächig aufgebracht ist, sodass es beispielsweise als ein einziger zusammenhängender Körper, der alle freiliegenden Stellen der Anschlussbereiche bedeckt, im strahlungsemittierenden Halbleiterbauteil vorhanden ist.

Gemäß der erfindungsgemäßen Ausführungsform des strahlungsemittierenden Halbleiterbauteils umfasst das strahlungsemittierende Halbleiterbauteil einen Gehäusekörper, der eine Chipmontagefläche aufweist. Beispielsweise kann der Gehäusekörper eine Kavität aufweisen, in der der zumindest eine strahlungsemittierende Halbleiterchip angeordnet ist. Die Chipmontagefläche des Gehäusekörpers ist dann durch die Chipmontagefläche dieser Kavität gebildet. Es ist jedoch auch möglich, dass es sich bei dem Gehäusekörper um eine quaderförmige Platte handelt, die frei von Ausnehmungen oder Kavitäten ist, in denen strahlungsemittierende Halbleiterchips angeordnet sind. Im Extremfall kann es sich bei dem Gehäusekörper um eine Leiterplatte handeln, bei der die Chipmontagefläche des Gehäusekörpers an der Seite angeordnet ist, an der auch der strahlungsemittierende Halbleiterchip montiert ist.

Der Chip-Anschlussbereich und/oder der Draht-Anschlussbereich sind in dieser Ausführungsform an der Chipmontagefläche des Gehäusekörpers angeordnet. Dabei ist die Chipmontagefläche stellenweise frei von Licht absorbierendem Material. Mit anderen Worten ist in der erfindungsgemäßen Ausführungsform nicht die gesamte Chipmontagefläche mit dem Licht absorbierenden Material bedeckt, sondern beispielsweise nur an solchen Stellen, an denen eine erhöhte Reflexion von Licht auftritt wie im Chip-Anschlussbereich und/oder im Draht-Anschlussbereich ist das Licht absorbierende Material angeordnet. Auf diese Weise wird relativ wenig Licht absorbierendes Material benötigt.

Beispielsweise sind das Metall oder die Metalle, die den Chip-Anschlussbereich und den Draht-Anschlussbereich bilden, mit dem Licht absorbierenden Material abgedeckt. Der Rest der Chipmontagefläche ist dann frei vom Licht absorbierenden Material. Zum Beispiel sind wenigstens 50% Prozent der Chipmontagefläche frei vom Licht absorbierenden Material.

Dabei ist es insbesondere möglich, dass die Chip-Montagefläche mit der gleichen Farbe oder in einer ähnlichen Farbe wie das Licht absorbierendem Material ausgebildet ist. Dabei kann auch der gesamte Gehäusekörper die gleiche Farbe oder eine ähnliche Farbe wie das Licht absorbierendem Material aufweisen. Im Blick auf das Halbleiterbauteil erscheint das Halbleiterbauteil, bis auf die Strahlungsaustrittflächen der Halbleiterchips, dann in einheitlicher Farbe. Es gibt keine störenden Reflexionen, zum Beispiel durch Metallisierungen an der Chipmontagefläche, die den Kontrast zu den Halbleiterchips stören können.

Gemäß zumindest einer nicht erfindungsgemäßen Ausführungsform des strahlungsemittierenden Halbleiterbauteils ist die Chipmontagefläche vollständig vom Licht absorbierenden Material bedeckt. Das heißt insbesondere, auch auf Bereiche der Chipmontagefläche, die vom Chip-Anschlussbereich und/oder vom Draht-Anschlussbereich beabstandet sind, befindet sich das Licht absorbierende Material. In dieser nicht erfindungsgemäßen Ausführungsform ist das Aufbringen des Licht absorbierenden Materials besonders einfach, da das Licht absorbierende Material nicht gezielt im Bereich der Anschlussbereiche abgeschieden werden muss.

Gemäß der erfindungsgemäßen Ausführungsform des strahlungsemittierenden Halbleiterbauteils umfasst das strahlungsemittierende Halbleiterbauteil ein lichtdurchlässiges Vergussmaterial. Das lichtdurchlässige Vergussmaterial ist im Wesentlichen frei vom Licht absorbierenden Material. Das Licht absorbierende Vergussmaterial kann dabei klarsichtig ausgebildet sein. Darüber hinaus ist es möglich, dass das lichtdurchlässige Vergussmaterial mit einem Leuchtstoff und/oder mit einem Diffusor gefüllt ist. Bei dem Leuchtstoff kann es sich beispielsweise um Partikel eines Lumineszenzkonversionsmaterials handeln, das zum Beispiel blaues Licht oder UV-Strahlung absorbiert und Strahlung mit größeren Wellenlängen reemittiert. Bei dem Diffusormaterial kann es sich beispielsweise um Partikel insbesondere eines keramischen Materials handeln, die zur Lichtstreuung geeignet sind.

Dass das Vergussmaterial im Wesentlichen frei vom Licht absorbierenden Material ist, bedeutet, dass das Licht absorbierende Material oder der Licht absorbierende Bestandteil des Licht absorbierenden Materials, wie beispielsweise Licht absorbierende Teilchen, nicht gezielt in das Vergussmaterial eingebracht ist. Durch Diffusionsprozesse an der Grenzfläche zwischen Vergussmaterial und Licht absorbierendem Material kann es jedoch dazu kommen, dass geringe Anteile des Licht absorbierenden Materials in das lichtdurchlässige Vergussmaterial diffundiert. Bevorzugt beträgt der Gewichtsanteil beispielsweise an strahlungsabsorbierenden Teilchen des Licht absorbierenden Materials im lichtdurchlässigen Vergussmaterial höchstens 1 %.

Das Vergussmaterial ist dabei derart im strahlungsemittierenden Halbleiterbauteil angeordnet, dass es stellenweise an das Licht absorbierende Material grenzt. Das heißt, das lichtdurchlässige Vergussmaterial bedeckt beispielsweise die freiliegenden Außenflächen des Licht absorbierenden Materials vollständig und kapselt somit das Licht absorbierende Material nach außen hin ab.

Gemäß zumindest einer Ausführungsform des strahlungsemittierenden Halbleiterbauteils sind der Gehäusekörper und das Licht absorbierende Material in der gleichen Farbe ausgebildet. Beispielsweise sind sowohl der Gehäusekörper als auch das Licht absorbierende Material schwarz ausgebildet.

Gemäß zumindest einer Ausführungsform des strahlungsemittierenden Halbleiterbauteils sind der Chip-Anschlussbereich und/oder der Draht-Anschlussbereich mit einem Metall wie beispielsweise Silber gebildet. Die Anschlussbereiche können dabei durch Metallisierungen gebildet sein. Die Metallisierungen sind beispielsweise auf ein Material des Gehäusekörpers aufgebracht. Der Gehäusekörper kann dazu mit einem Kunststoffmaterial und/oder mit einem keramischen Material gebildet sein. Es ist aber auch möglich, dass die Metallisierung auf einen metallischen Leiterrahmen, der beispielsweise mit Kupfer gebildet ist, aufgebracht ist. Ferner ist es möglich, dass es sich bei den Anschlussbereichen um Teile eines solchen elektrischen Leiterrahmens (englisch auch leadframe) handelt, die nicht mit einer zusätzlichen Metallisierung versehen sind.

Gemäß zumindest einer Ausführungsform des strahlungsemittierenden Halbleiterbauteils hemmt das Licht absorbierende Material die Migration des Metalls also zum Beispiel des Silbers der Anschlussbereiche. Dazu können beispielsweise Licht absorbierende Partikel des Licht absorbierenden Materials derart ausgebildet sein, dass eine Migration insbesondere im elektrischen Feld von beispielsweise Ionen des Metalls oder des Silbers durch die Partikel gehemmt ist. Ferner ist es möglich, dass das Licht absorbierende Material weitere Füllstoffe aufweist, welche die Migration im elektrischen Feld hemmen. Bei den Füllstoffen kann es sich beispielsweise um Partikel eines keramischen Materials oder Partikel aus Titandioxid handeln.

Insbesondere, wenn der Chip-Anschlussbereich und/oder der Draht-Anschlussbereich mit einem Metall wie Silber gebildet sind, ergibt sich als weiterer Vorteil, dass eine eventuelle Oxidation oder Korrosion des Metalls der Anschlussbereiche oder des Anschlussbereichs nach dem Abdecken der freiliegenden Stellen der Anschlussbereiche durch das Licht absorbierende Material von außen nicht mehr erkennbar ist oder verhindert wird. Das heißt, es ist auch möglich, dass das Licht absorbierende Material eine Oxidation und/oder Korrosion des Metalls der Anschlussbereiche oder des Anschlussbereichs hemmt, verzögert oder verhindert.

Gemäß zumindest einer Ausführungsform des strahlungsemittierenden Halbleiterbauteils ist das Licht absorbierende Material mit einem Jetprozess aufgebracht. Ferner ist es möglich, dass das Licht absorbierende Material mittels eines Moldprozesses, mittels selektiven Abscheidens (zum Beispiel mittels eines Plasmasprayprozess), mittels eines Siebdrucks, mittels Sputterns oder mittels Sprühens aufgebracht ist. Die einzelnen Aufbringprozesse sind dabei am fertigen Produkt voneinander unterscheidbar. Es handelt sich daher bei diesen Aufbringprozessen für das Licht absorbierende Material um gegenständliche Merkmale, die am fertigen strahlungsemittierenden Halbleiterbauteil nachweisbar sind.

Gemäß zumindest einer Ausführungsform des strahlungsemittierenden Halbleiterbauteils umfasst das Licht absorbierende Material ein Silikon, in das Licht absorbierende Teilchen eingebracht sind. Bei den Licht absorbierenden Teilchen kann es sich beispielsweise um Rußpartikel handeln. Bei dem Ruß handelt es sich bevorzugt um amorphen Ruß (englisch auch amorphous carbon black). Der Anteil des Absorbers - zum Beispiel der Rußpartikel - im Matrixmaterial - zum Beispiel dem Silikon - des strahlungsemittierenden Halbleiterbauteils beträgt bevorzugt zwischen wenigstens 7 Gewichts-% und höchstens 13 Gewichts-%, zum Beispiel 10 Gewichts-%.

Für ein viskoses Material wie beispielsweise Silikon stellt ein Jetprozess eine besonders geeignete Methode zum Aufbringen des Licht absorbierenden Materials dar.

Das hier beschriebene strahlungsemittierende Halbleiterbauteil eignet sich besonders gut zur Verwendung in so genannten Videowänden, bei denen einzelne Bildpunkte durch strahlungsemittierende Halbleiterchips des strahlungsemittierenden Halbleiterbauteils gebildet sind. Das hier beschriebene strahlungsemittierende Halbleiterbauteil zeichnet sich durch den hohen Kontrast zwischen ausgeschaltetem und eingeschaltetem Zustand des strahlungsemittierenden Halbleiterbauteils aus. Durch das Abdecken der hellen Bereiche im strahlungsemittierenden Halbleiterbauteil, wie beispielsweise der Anschlussbereiche, mit dem Licht absorbierenden Material entsteht ein strahlungsemittierendes Halbleiterbauteil, das im ausgeschalteten Zustand in Draufsicht beispielsweise vollständig schwarz erscheint. Dadurch, dass der strahlungsemittierende Halbleiterchip stellenweise frei vom Licht absorbierenden Material bleibt, ist eine hohe Helligkeit des vom strahlungsemittierenden Halbleiterbauteil abgestrahlten Lichts oder der vom strahlungsemittierenden Halbleiterbauteil abgestrahlten elektromagnetischen Strahlung erreichbar.

Es wird ferner eine Anzeigevorrichtung angegeben, wobei Bildpunkte (Pixel) der Anzeigevorrichtung durch hier beschriebene strahlungsemittierende Halbeiterbauteile gebildet sind. Bei der Anzeigevorrichtung handelt es sich zum Beispiel um eine großflächige Videowand, die eine Displayfläche von wenigstens 5 m² aufweist.

Im Folgenden wird das hier beschriebene strahlungsemittierende Halbleiterbauteil anhand von Ausführungsbeispielen und den dazugehörigen Figuren näher erläutert.
- Die Figuren 1A, 1B: zeigen schematische Ansichten eines strahlungsemittierenden Halbleiterbauteils ohne das hier beschriebene Licht absorbierende Material.
- Die Figuren 2, 3A, 3B, 3C, 4A, 4B, 4C, 5, 6, 7: zeigen anhand schematischer Darstellungen Ausführungsbeispiele eines hier beschriebenen strahlungsemittierenden Halbleiterbauteils.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

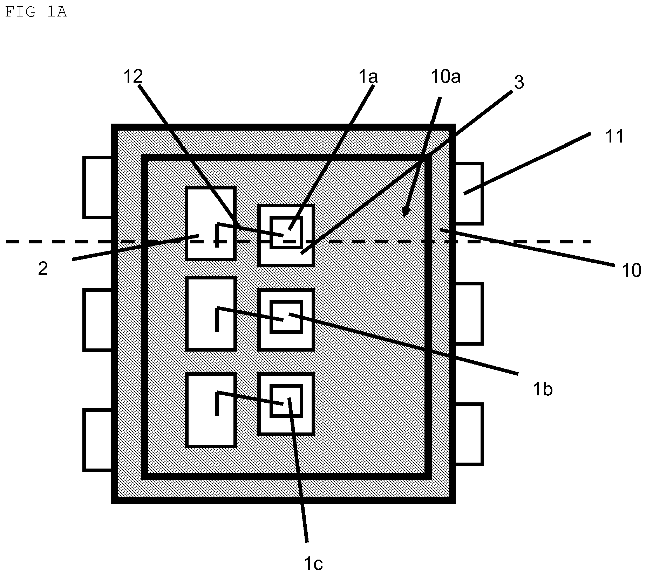

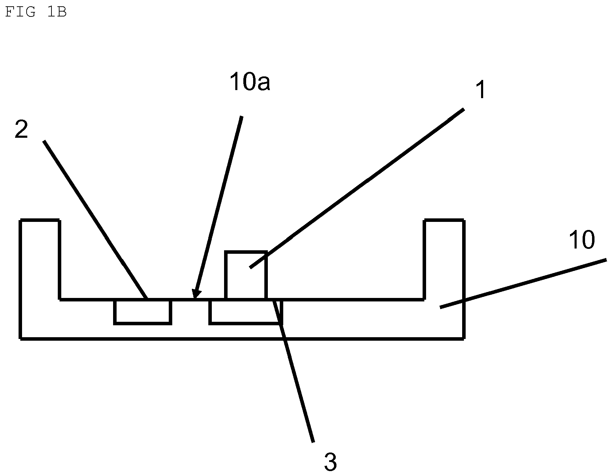

Die Figur 1A zeigt eine schematische Draufsicht eines strahlungsemittierenden Halbleiterbauteils ohne das hier beschriebene Licht absorbierende Material. Die Figur 1B zeigt die dazugehörige Schnittdarstellung entlang der in der Figur 1A eingezeichneten gestrichelten Linie.

Vorliegend umfasst das strahlungsemittierende Halbleiterbauteil einen Gehäusekörper 10, der beispielsweise mit einem Kunststoffmaterial oder mit einem Keramikmaterial gebildet ist. Der Gehäusekörper 10 ist vorliegend schwarz ausgebildet.

Seitlich aus dem Gehäusekörper 10 ragen elektrische Anschlussstellen 11, über die strahlungsemittierende Halbleiterchips 1a, 1b, 1c des strahlungsemittierenden Halbleiterbauteils elektrisch kontaktiert werden können. Bei den elektrischen Anschlussstellen 11 handelt es sich beispielsweise um Teile eines elektrischen Leiterrahmens, die im Gehäusekörper 10 an dessen Chipmontagefläche 10a freiliegen. Dort bilden sie Draht-Anschlussbereiche 2 und Chip-Anschlussbereiche 3. Die elektrischen Anschlussstellen 11 können mit einem Metall wie Kupfer gebildet sein, das gegebenenfalls zumindest stellenweise mit einem weiteren Metall wie Silber oder Gold beschichtet ist.

Auf die Chip-Anschlussbereiche 3 sind strahlungsemittierende Halbleiterchips 1a, 1b, 1c aufgebracht. Vorliegend umfasst das strahlungsemittierende Halbleiterbauteil drei unterschiedliche strahlungsemittierende Halbleiterchips. Es ist jedoch auch möglich, dass das strahlungsemittierende Halbleiterbauteil mehr oder weniger strahlungsemittierende Halbleiterchips umfasst. Vorliegend umfasst das strahlungsemittierende Halbleiterbauteil einen rotes Licht emittierenden strahlungsemittierenden Halbleiterchip 1a, einen grünes Licht emittierenden strahlungsemittierenden Halbleiterchip 1b, und einen blaues Licht emittierenden strahlungsemittierenden Halbleiterchip 1c. Die strahlungsemittierenden Halbleiterchips 1a, 1b, 1c sind jeweils mittels eines Drahtes 12 mit dazugehörigen Draht-Anschlussbereichen 2 elektrisch leitend verbunden.

Bei den strahlungsemittierenden Halbleiterchips handelt es sich beispielsweise um Leuchtdiodenchips. Ein solches strahlungsemittierendes Halbleiterbauteil kann beispielsweise einen Bildpunkt einer Anzeigevorrichtung bilden, deren Bildpunkte durch eine Vielzahl gleichartig ausgebildeter strahlungsemittierender Halbleiterbauteile gegeben sind.

Aufgrund ihrer metallischen Reflektivität weisen die Anschlussbereiche 2, 3 eine höhere Reflektivität als der beispielsweise schwarz ausgebildete Gehäusekörper 10 auf. Dies kann sich beim Einsatz des strahlungsemittierenden Halbleiterbauteils als störend erweisen.

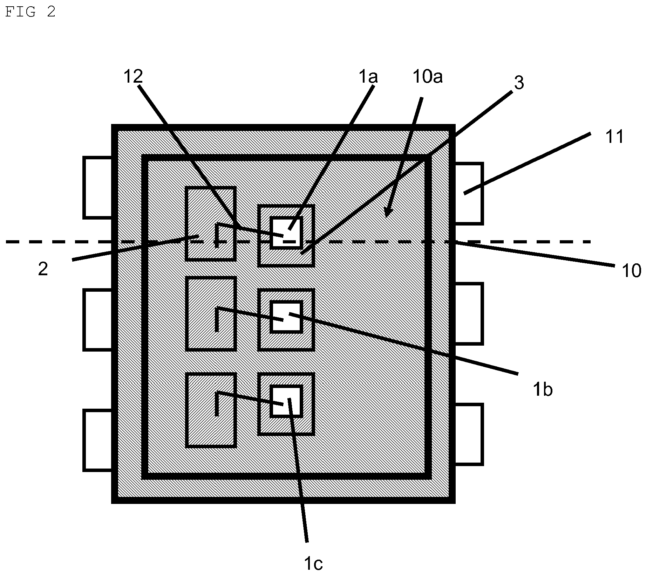

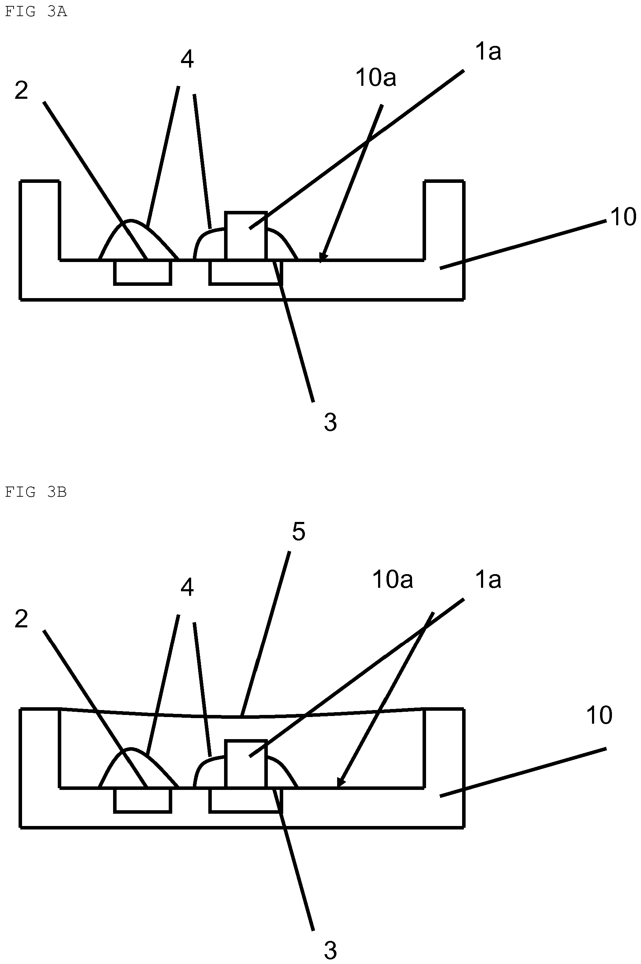

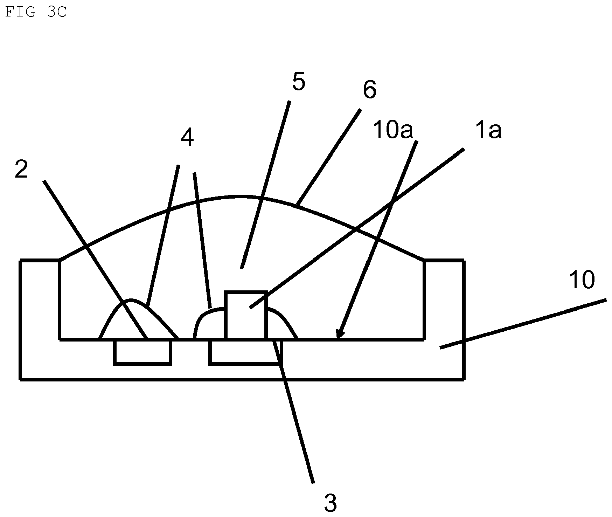

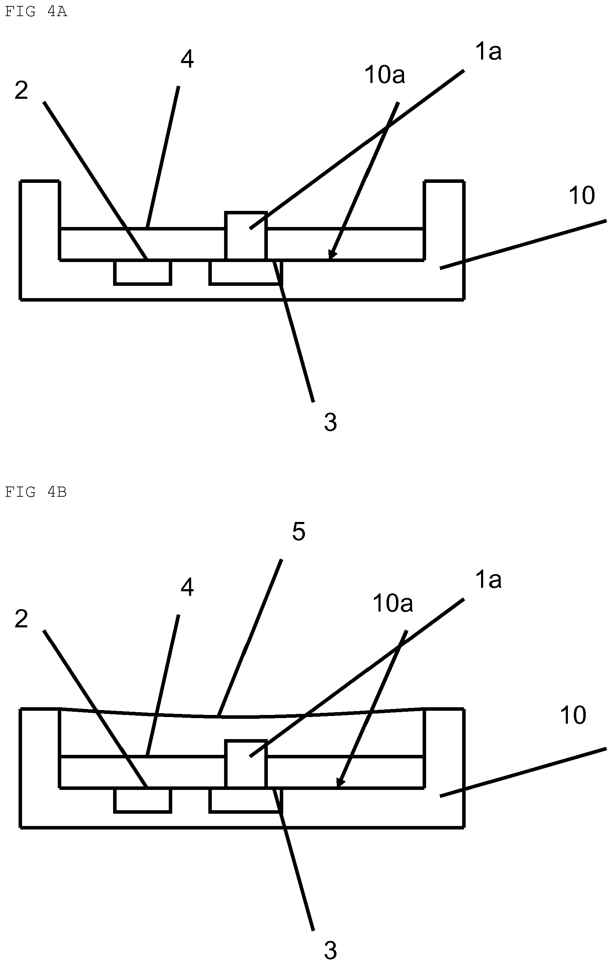

Anhand der schematischen Draufsicht der Figur 2 ist ein Ausführungsbeispiel eines hier beschriebenen strahlungsemittierenden Halbleiterbauteils näher erläutert. Im Unterschied zum in Verbindung mit den Figuren 1A, 1B beschriebenen Ausführungsbeispiel sind die freiliegenden Stellen der Draht-Anschlussbereiche 2 und der Chip-Anschlussbereiche 3 mit einem Licht absorbierenden Material 4 bedeckt (vergleiche dazu auch die Figuren 3A, 3B, 3C, 4A, 4B).

Das Licht absorbierende Material 4 weist vorzugsweise die gleiche oder eine ähnliche Farbe wie die Chipmontagefläche 10a des Gehäusekörpers 10 oder wie der Gehäusekörper 10 auf. Bei dem Licht absorbierenden Material handelt es sich beispielsweise um ein Silikon, in das Licht absorbierende Teilchen eingebracht sind. Beispielsweise handelt es sich bei den Licht absorbierenden Teilchen um Rußpartikel.

In Verbindung mit der schematischen Schnittdarstellung der Figur 3A ist eine Möglichkeit zur Einbringung des Licht absorbierenden Materials 4 näher dargestellt. In diesem Ausführungsbeispiel ist das Licht absorbierende Material 4 gezielt im Bereich der Draht-Anschlussbereiche 2 und der Chip-Anschlussbereiche 3 aufgebracht. Die verbleibende Chipmontagefläche 10a, die beabstandet von den Anschlussbereichen 2, 3 ist, bleibt vom Licht absorbierenden Material 4 unbedeckt. Sie ist in diesem Fall selbst in der gleichen Farbe oder in einer ähnlichen Farbe wie das Licht absorbierende Material ausgebildet, sodass aus einiger Entfernung, zum Beispiel in einer Entfernung ab 10 cm vom Auge des Betrachters, von außen nicht erkennbar ist, dass Teile der Chipmontagefläche 10a nicht mit dem Licht absorbierenden Material 4 bedeckt sind. Das Licht absorbierende Material 4 befindet sich vorliegend in direktem Kontakt mit Seitenflächen des strahlungsemittierenden Halbleiterchips 1a. Dies kann für alle strahlungsemittierenden Halbleiterchips des Halbleiterbauteils in gleicher Weise ausgeführt sein.

Die der Chipmontagefläche 10a abgewandten Oberfläche der strahlungsemittierenden Halbleiterchips 1a, 1b, 1c bleiben dann frei oder im Wesentlichen frei vom Licht absorbierenden Material 4.

Im erfindungsgemäßen Ausführungsbeispiel der Figur 3B ist zusätzlich zum Licht absorbierenden Material 4 ein durchlässiges Vergussmaterial 5 auf die Chipmontagefläche 10a aufgebracht, das sich vorliegend stellenweise in direktem Kontakt mit der Chipmontagefläche 10a befindet. Bei dem lichtdurchlässigen Vergussmaterial 5 handelt es sich beispielsweise um ein Vergussmaterial, das Silikon enthält oder aus Silikon besteht. Das Vergussmaterial befindet sich stellenweise in direktem Kontakt mit freiliegenden Außenflächen des Licht absorbierenden Materials 4. Das lichtdurchlässige Vergussmaterial ist vorzugsweise frei von beispielsweise den Licht absorbierenden Teilchen des Licht absorbierenden Materials 4.

Im in Verbindung mit der Figur 3C beschriebenen erfindungsgemäßen Ausführungsbeispiel ist das Vergussmaterial 5 an seiner der Chipmontagefläche 10a abgewandten Oberseite konvex nach außen gekrümmt und formt auf diese Weise eine Linse aus.

Im in Verbindung mit der Figur 4A erläuterten nicht erfindungsgemäßen Ausführungsbeispiel bedeckt das Licht absorbierende Material 4 die Chipmontagefläche 10a vollständig. In diesem Fall ist es möglich, dass die Chipmontagefläche 10a in einer anderen Farbe, beispielsweise weiß, ausgebildet ist als das Licht absorbierende Material. Das Licht absorbierende Material 4 ist jedoch vorzugsweise in der gleichen Farbe wie die in der Draufsicht sichtbaren Außenflächen des Gehäusekörpers 10 ausgebildet. Diese Außenflächen können zum Beispiel mit schwarzer Farbe bedruckt sein.

Wie in Verbindung mit der Figur 4B ersichtlich ist, kann das lichtdurchlässige Vergussmaterial 5 auch in diesem Fall direkt an das Licht absorbierende Material 4 und den oder die strahlungsemittierenden Halbleiterchips 1a, 1b, 1c grenzen und sich in direktem Kontakt mit diesen Komponenten befinden.

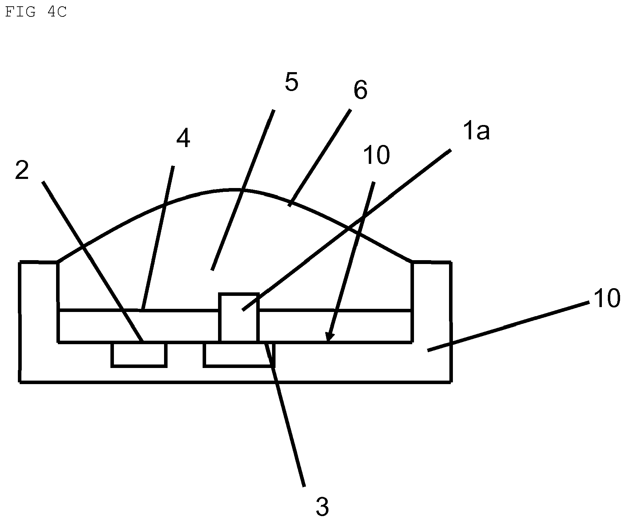

Auch eine linsenartige Ausgestaltung der der Chipmontagefläche 10a abgewandten Oberseite des lichtdurchlässigen Vergussmaterials 5 ist möglich (siehe Figur 4C).

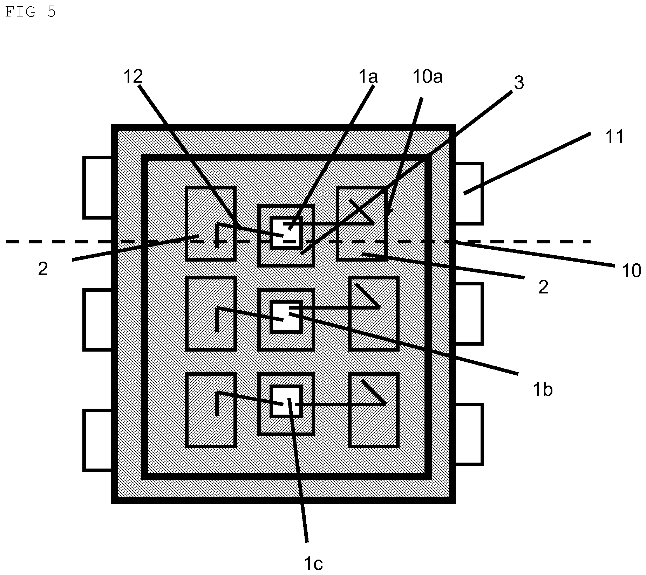

Anhand der schematischen Draufsicht der Figur 5 ist ein weiteres Ausführungsbeispiel eines hier beschriebenen strahlungsemittierenden Halbleiterbauteils näher erläutert. Im Unterschied zum in Verbindung mit der Figur 2 erläuterten Ausführungsbeispiel umfasst das Halbleiterbauteil im vorliegenden Ausführungsbeispiel für jeden der strahlungsemittierenden Halbleiterchips 1a, 1b, 1c zwei Draht-Anschlussbereiche 2. Das heißt, jeder der strahlungsemittierenden Halbleiterchips 1a, 1b, 1c umfasst zwei oberseitige Kontaktstellen (nicht dargestellt), über die er mit einem Draht 12 jeweils mit einem Draht-Anschlussbereich 2 elektrisch leitend verbunden ist. Die Draht-Anschlussbereiche 2 sind dabei wie beispielsweise in Verbindung mit den Figuren 3A, 3B, 3C, 4A, 4B, 4C beschrieben, mit dem Licht absorbierenden Material 4 an freiliegenden Stellen bedeckt.

Beim in Verbindung mit der Figur 5 beschriebenen Ausführungsbeispiel können die strahlungsemittierenden Halbleiterchips 1a, 1b, 1c insbesondere ein Trägerelement oder ein Aufwachssubstrat aufweisen, das mit einem elektrisch isolierenden Material wie Saphir oder SiC gebildet ist.

Der Chipanschlussbereich 3 muss im Ausführungsbeispiel der Figur 5 nicht mit einem reflektierenden Material, wie beispielsweise einem Metall gebildet sein. Insbesondere ist es möglich, dass ein Abdecken von freiliegenden Stellen der Chip-Anschlussbereiche 3 beim Ausführungsbeispiel der Figur 5 nicht notwendig ist. Es kann in diesem Fall auch lediglich ein Abdecken der freiliegenden Stellen der Draht-Anschlussbereiche 2 erfolgen.

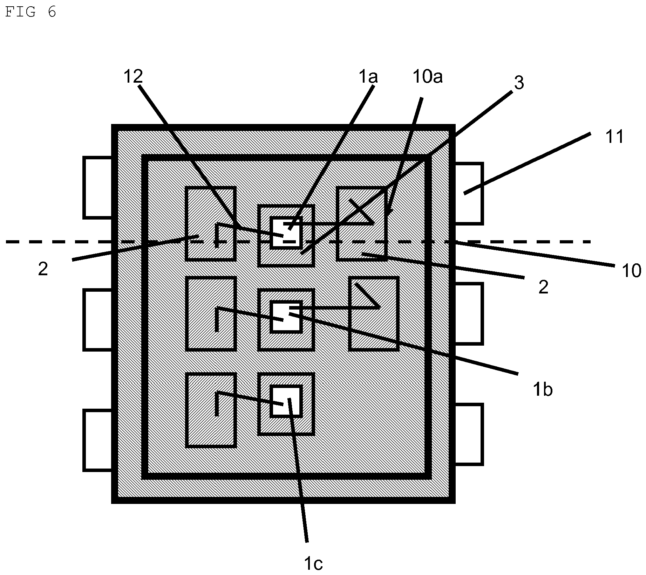

In Verbindung mit der Figur 6 ist ein weiteres Ausführungsbeispiel eines hier beschriebenen strahlungsemittierenden Halbleiterbauteils näher erläutert. Im Unterschied zum Ausführungsbeispiel der Figur 5 umfassen in diesem Ausführungsbeispiel nur zwei der strahlungsemittierenden Halbleiterchips 1a, 1b zwei Draht-Anschlussbereiche 2, wobei dem dritten strahlungsemittierenden Halbleiterchip 1c ein einziger Draht-Anschlussbereich 2 zugeordnet ist.

Das heißt, beim hier beschriebenen strahlungsemittierenden Halbleiterbauteil können auch unterschiedliche Typen von strahlungsemittierenden Halbleiterchips Verwendung finden, wobei die Chips voneinander unterschiedlich kontaktiert werden können. Beispielsweise kann zumindest einer der strahlungsemittierenden Halbleiterchips einen rückseitigen und einen vorderseitigen Kontakt aufweisen, wie der strahlungsemittierenden Halbleiterchip 1c in der Figur 6, zumindest einer der strahlungsemittierenden Halbleiterchips kann lediglich vorderseitige oder lediglich rückseitige Kontakte aufweisen, wie beispielsweise die strahlungsemittierenden Halbleiterchips 1a, 1b der Figur 6.

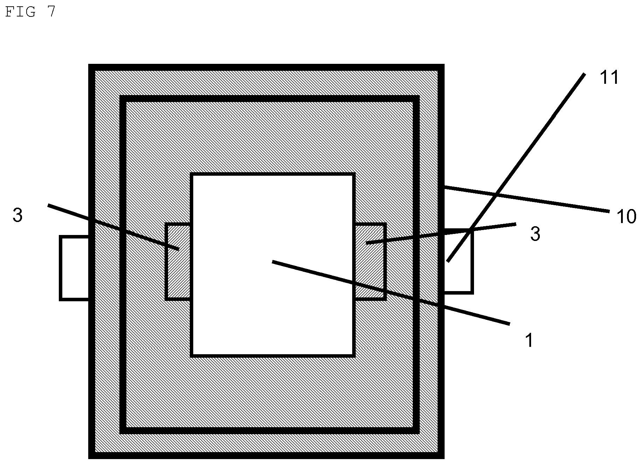

In Verbindung mit der Figur 7 ist ein weiteres Ausführungsbeispiel eines hier beschriebenen strahlungsemittierenden Halbleiterbauteils erläutert. In diesem Ausführungsbeispiel weist das strahlungsemittierende Halbleiterbauteil einen einzigen strahlungsemittierenden Halbleiterchip 1 auf. Beispielsweise wird vom strahlungsemittierenden Halbleiterbauteil im Betrieb weißes Licht abgestrahlt.

Das strahlungsemittierenden Halbleiterbauteil umfasst vorliegenden zwei Chip-Anschlussbereiche 3, die jeweils mit zugehörigen rückseitigen Kontaktstellen (nicht dargestellt) des Halbleiterchips 1 elektrisch leitend verbunden sind. Die vom Halbleiterchip 1 nicht überdeckten Stellen der Chip-Anschlussbereiche 3 sind mit dem Licht absorbierenden Material 4 überdeckt, wie dies beispielsweise in einer der Figuren 3A, 3B, 3C, 4A, 4B, 4C näher erläutert ist. Ein wie in der Figur 7 gezeigter strahlungsemittierenden Halbleiterchip 1, der lediglich über rückseitige Kontakte verfügt, kann dabei auch in hier beschriebenen strahlungsemittierenden Halbleiterbauteilen mit zwei oder mehr strahlungsemittierenden Halbleiterchips Verwendung finden.

Diese Patentanmeldung beansprucht die Priorität der deutschen Patentanmeldung DE102010012602.

Die Erfindung ist nicht durch die Beschreibung anhand der Ausführungsbeispiele auf diese beschränkt.

## Patentansprüche

1. Strahlungsemittierendes Halbleiterbauteil mit
- einem Gehäusekörper (10), der eine Chipmontagefläche (10a) aufweist
- einem Chip-Anschlussbereich (3) und Draht-Anschlussbereich (2),
- einem strahlungsemittierenden Halbleiterchip (1),
- einem Draht (12), der den Draht-Anschlussbereich (2) elektrisch leitend mit dem strahlungsemittierenden Halbleiterchip (1) verbindet,
- einem lichtdurchlässigen Vergussmaterial (5), und
- einem Licht absorbierendem Material (4), wobei
- der Chip-Anschlussbereich (3) und der Draht-Anschlussbereich (2) an der Chipmontagefläche (10a) angeordnet sind,
- der strahlungsemittierende Halbleiterchip (1) am Chip-Anschlussbereich (3) befestigt ist,
- der Chip-Anschlussbereich (3) an Stellen, an denen er vom strahlungsemittierenden Halbleiterchip (1) unverdeckt ist, mit dem Licht absorbierendem Material (4) bedeckt ist,
- der strahlungsemittierende Halbleiterchip (1) stellenweise frei vom Licht absorbierendem Material (4) ist,
- der Draht-Anschlussbereich (2) an Stellen, an denen er vom Draht (12) unverdeckt ist, mit dem Licht absorbierendem Material (4) bedeckt ist,
- das Vergussmaterial (5) im Wesentlichen frei von dem Licht absorbierendem Material (4) ist, und
- das Vergussmaterial (5) stellenweise an den strahlungsemittierenden Halbleiterchip (1) und das Licht absorbierende Material (4) grenzt, **dadurch gekennzeichnet, dass**
- die Chipmontagefläche (10a) stellenweise frei vom Licht absorbierenden Material (4) ist, und
- das Vergussmaterial (5) stellenweise an die Chipmontagefläche (10a) grenzt.

2. Strahlungsemittierendes Halbleiterbauteil nach dem vorherigen Anspruch,
bei dem die Chip-Montagefläche (10a) mit der gleichen Farbe oder in einer ähnlichen Farbe wie das Licht absorbierendem Material (4) ausgebildet sind.

3. Strahlungsemittierendes Halbleiterbauteil nach einem der vorherigen Ansprüche,
bei dem das Vergussmaterial (5) klarsichtig ausgebildet ist.

4. Strahlungsemittierendes Halbleiterbauteil nach einem der vorherigen Ansprüche,
bei dem das Vergussmaterial (5) mit einem Leuchtstoff und/oder einem Diffuser gefüllt ist.

5. Strahlungsemittierendes Halbleiterbauteil nach einem der vorherigen Ansprüche,
bei dem der Gehäusekörper (10) und das Licht absorbierende Material (4) in der gleichen Farbe ausgebildet sind.

6. Strahlungsemittierendes Halbleiterbauteil nach einem der vorherigen Ansprüche,
bei dem der Chip-Anschlussbereich (3)und/oder der Draht-Anschlussbereich (2) mit einem Metall, insbesondere mit Silber, gebildet sind.

7. Strahlungsemittierendes Halbleiterbauteil nach Anspruch 6, bei dem das Licht absorbierende Material (4) die Migration und/oder die Oxidation und/oder die Korrosion des Metalls oder des Silbers hemmt.

8. Strahlungsemittierendes Halbleiterbauteil nach einem der vorherigen Ansprüche,
bei dem das Licht absorbierende Material (4) mittels eines Jetprozesses aufgebracht ist.

9. Strahlungsemittierendes Halbleiterbauteil nach einem der vorherigen Ansprüche,
bei dem das Licht absorbierende Material (4) ein Silikon umfasst, in das Licht absorbierende Teilchen eingebracht sind.

10. Anzeigevorrichtung, wobei zumindest ein Bildpunkt der Anzeigevorrichtung zumindest teilweise durch ein strahlungsemittierendes Halbleiterbauteil nach einem der vorherigen Ansprüche gebildet ist.

## Claims

1. Radiation-emitting semiconductor device comprising
- a housing body (10) having a chip mounting area (10a),
- a chip connection region (3) and wire connection region (2),
- a radiation-emitting semiconductor chip (1),
- a wire (12), which electrically conductively connects the wire connection region (2) to the radiation-emitting semiconductor chip (1),
- a light-transmissive potting material (5), and
- a light-absorbing material (4), wherein
- the chip connection region (3) and the wire connection region (2) are arranged at the chip mounting area (10a),
- the radiation-emitting semiconductor chip (1) is fixed to the chip connection region (3),
- the chip connection region (3) is covered with the light-absorbing material (4) at locations at which said chip connection region is not covered by the radiation-emitting semiconductor chip (1),
- the radiation-emitting semiconductor chip (1) is free of the light-absorbing material (4) in places,
- the wire connection region (2) is covered with the light-absorbing material (4) at locations at which it is not covered by the wire (12),
- the potting material (5) is substantially free of the light-absorbing material (4), and
- the potting material (5) adjoins the radiation-emitting semiconductor chip (1) and the light-absorbing material (4) in places, **characterized in that**
- the chip mounting area (10a) is free of the light-absorbing material (4) in places, and
- the potting material (5) adjoins the chip mounting area (10a) in places.

2. Radiation-emitting semiconductor device according to the preceding claim,
wherein the chip mounting area (10a) is formed with the same colour as, or in a similar colour to, the light absorbing material (4).

3. Radiation-emitting semiconductor device according to either of the preceding claims,
wherein the potting material (5) is embodied in transparent fashion.

4. Radiation-emitting semiconductor device according to any of the preceding claims,
wherein the potting material (5) is filled with a luminescent material and/or a diffuser.

5. Radiation-emitting semiconductor device according to any of the preceding claims,
wherein the housing body (10) and the light-absorbing material (4) are embodied in the same colour.

6. Radiation-emitting semiconductor device according to any of the preceding claims,
wherein the chip connection region (3) and/or the wire connection region (2) are formed with a metal, in particular with silver.

7. Radiation-emitting semiconductor device according to Claim 6,
wherein the light-absorbing material (4) inhibits the migration and/or the oxidation and/or the corrosion of the metal or of the silver.

8. Radiation-emitting semiconductor device according to any of the preceding claims,
wherein the light-absorbing material (4) is applied by means of a jet process.

9. Radiation-emitting semiconductor device according to any of the preceding claims,
wherein the light-absorbing material (4) comprises a silicone into which light-absorbing particles are introduced.

10. Display apparatus, wherein at least one pixel of the display apparatus is formed at least partly by a radiation-emitting semiconductor device according to any of the preceding claims.

## Revendications

1. Composant semi-conducteur émetteur de rayonnement, comportant
- un corps de boîtier (10) présentant une surface de montage de puce (10a),
- une zone de connexion de puce (3) et une zone de connexion de fil (2),
- une puce semi-conductrice émettrice de rayonnement (1),
- un fil (12) qui relie de manière électriquement conductrice la zone de connexion de fil (2) à la puce semi-conductrice émettrice de rayonnement (1),
- un matériau d'enrobage (5) transparent, et
- un matériau absorbant la lumière (4), dans lequel
- la zone de connexion de puce (3) et la zone de connexion de fil (2) sont disposées sur la surface de montage de puce (10a),
- la puce semi-conductrice émettrice de rayonnement (1) est fixée à la zone de connexion de puce (3),
- la zone de connexion de puce (3) est recouverte, à des endroits dans lesquels elle n'est pas couverte par la puce semi-conductrice émettrice de rayonnement (1), par le matériau absorbant la lumière (4),
- la puce semi-conductrice émettrice de rayonnement (1) est par endroits dépourvue du matériau absorbant la lumière (4),
- la zone de connexion de fil (2) est recouverte, à des endroits dans lesquels elle n'est pas couverte par le fil (12), par le matériau absorbant la lumière (4),
- le matériau d'enrobage (5) est sensiblement dépourvu du matériau absorbant la lumière (4), et
- le matériau d'enrobage (5) est par endroits adjacent à la puce semi-conductrice émettrice de rayonnement (1) et au matériau absorbant la lumière (4),
**caractérisé en ce que**
- la surface de montage de puce (10a) est par endroits dépourvue du matériau absorbant la lumière (4), et
- le matériau d'enrobage (5) est par endroits adjacent à la surface de montage (10a).

2. Composant semi-conducteur émetteur de rayonnement selon la revendication précédente,
dans lequel la surface de montage de puce (10a) est réalisée de manière à présenter la même couleur que le matériau absorbant la lumière (4) ou une couleur semblable à celle-ci.

3. Composant semi-conducteur émetteur de rayonnement selon l'une quelconque des revendications précédentes,
dans lequel le matériau d'enrobage (5) est réalisé de manière à être translucide.

4. Composant semi-conducteur émetteur de rayonnement selon l'une quelconque des revendications précédentes,
dans lequel le matériau d'enrobage (5) est rempli de matériau luminescent et/ou d'un diffusant.

5. Composant semi-conducteur émetteur de rayonnement selon l'une quelconque des revendications précédentes,
dans lequel le corps de boîtier (10) et le matériau absorbant la lumière (4) sont réalisés de manière à présenter la même couleur.

6. Composant semi-conducteur émetteur de rayonnement selon l'une quelconque des revendications précédentes,
dans lequel la zone de connexion de puce (3) et/ou la zone de connexion de fil (2) sont réalisés en métal, notamment en argent.

7. Composant semi-conducteur émetteur de rayonnement selon la revendication 6,
dans lequel le matériau absorbant la lumière (4) inhibe la migration et/ou l'oxydation et/ou la corrosion du métal ou de l'argent.

8. Composant semi-conducteur émetteur de rayonnement selon l'une quelconque des revendications précédentes,
dans lequel le matériau absorbant la lumière (4) est appliqué par un processus utilisant un jet.

9. Composant semi-conducteur émetteur de rayonnement selon l'une quelconque des revendications précédentes,
dans lequel le matériau absorbant la lumière (4) comprend une silicone dans laquelle sont introduites des particules absorbant la lumière.

10. Dispositif d'affichage, dans lequel au moins un pixel du dispositif d'affichage est formé au moins partiellement par un composant semi-conducteur émetteur de rayonnement selon l'une quelconque des revendications précédentes.
